# EUROPÄISCHE PATENTSCHRIFT

(11) **EP 1 370 495 B1**
(45) Veröffentlichungstag und Bekanntmachung des Hinweises auf die Patenterteilung: **15.11.2006**
(21) Anmeldenummer: 02748301.5
(22) Anmeldetag: 05.03.2002
(51) Int. Cl.: C03B 19/09, C30B 15/10, C03C 10/00

(54) **VERFAHREN ZUR HERSTELLUNG EINES QUARZGLASTIEGELS**
METHOD FOR PRODUCING A QUARTZ GLASS CRUCIBLE
PROCEDE DE FABRICATION D'UN CREUSET EN VERRE DE QUARTZ

(30) Priorität: 08.03.2001 DE 10111405; 11.08.2001 DE 10139648
(43) Veröffentlichungstag der Anmeldung: 17.12.2003
(73) Patentinhaber: Heraeus Quarzglas GmbH & Co. KG, 63450 Hanau (DE)
(72) Erfinder: KORUS, Gabriele, 04109 Leipzig (DE); LAUDAHN, Hilmar, 06749 Bitterfeld (DE); ARNDT, Martin, 06749 Bitterfeld (DE); GERTIG, Udo, 63687 Johannesberg (DE)
(74) Vertreter: Staudt, Armin Walter
(86) Internationale Anmeldenummer: PCT/EP2002/002395
(87) Internationale Veröffentlichungsnummer: WO 2002/070414

(56) Entgegenhaltungen:
- EP-A- 0 911 429
- WO-A-02/16677
- US-A- 4 102 666
- US-A- 5 389 582

## Beschreibung

Die Erfindung betrifft ein Verfahren zur Herstellung eines Quarzglastiegels zum Einsatz in einem Siliciumkristall-Ziehprozess nach dem Czochralski-Verfahren, in dem auf einem Tiegelbasiskörper aus Quarzglas mindestens teilweise eine Innenschicht aus SiO₂ unter Einsatz eines Lichtbogenschmelzverfahrens aufgeschmolzen wird, die beim bestimmungsgemäßen Einsatz des Quarzglastiegels mit einer Metallschmelze in Kontakt ist, und in welcher dabei unter Einsatz eines Kristallisationspromotors eine Cristobalitbildung herbeigeführt wird.

Derartige Quarzglastiegel werden beispielsweise zur Aufnahme der Metallschmelze beim Ziehen von Einkristallen nach dem sogenannten Czochralski-Verfahren eingesetzt. Bei diesem Verfahren wird ein Impfkristall mit vorgegebener Orientierungsrichtung in die Schmelze eingetaucht und dann langsam hochgezogen. Impfkristall und Schmelze rotieren dabei gegenläufig. Die Oberflächenspannung zwischen Impfkristall und Schmelze bewirkt, dass mit dem Impfkristall auch ein wenig Schmelze abgezogen wird, die allmählich erkaltet und dadurch zu dem stetig weiterwachsenden Einkristall erstarrt. Bei diesem Ziehprozess unterliegt der Quarzglastiegel hohen mechanischen, chemischen und thermischen Belastungen, denen der Quarzglastiegel über mehrere Stunden ohne merkliche plastische Verformungen standhalten muss. Im Fall einer Siliziumschmelze beträgt die Schmelztemperatur beispielsweise mehr als 1400°C.

Um die thermische Stabilität der Quarzglastiegel zu erhöhen ist daher vorgeschlagen worden, diese mit einer Oberflächenschicht aus Cristobalit zu versehen. Der Schmelzpunkt von Cristobalit liegt bei etwa 1720 °C. Ein derartiges Verfahren ist in der EP-A 748 885 beschrieben. Dabei wird die glasige Außenwandung eines handelsüblichen Tiegels aus opakem, blasenhaltigem Quarzglas mit einer chemischen Lösung behandelt, die Substanzen enthält, die eine Entglasung von Quarzglas zu Cristobalit fördern. Als kristallisationsfördernde Substanzen (im folgenden auch als "Kristallisationspromotor" bezeichnet) werden Bor-, Erdalkali- und Phosphorverbindungen empfohlen. Bevorzugt wird Bariumhydroxid eingesetzt. Beim Aufheizen des Quarzglastiegels - zum Beispiel während des bestimmungsgemäßen Einsatzes beim Ziehprozess - kristallisiert die vorbehandelte Tiegelwandung unter Bildung von Cristobalit aus, was zu einer höheren mechanischen und thermischen Festigkeit des Quarzglastiegels führt.

Die mittels des bekannten Verfahrens hergestellten Quarzglastiegel halten langen Prozessdauern beim Ziehen von Silizium-Einkristallen jedoch nur beschränkt stand. Die Stärke der kristallisierten Oberflächenschicht beträgt in der Regel weniger als 1 mm und ist damit relativ dünn. Es hat sich gezeigt, dass nach einer gewissen Zeit eine allmähliche Ablösung der kristallisierten Oberflächenschicht einsetzt, wobei die kristallisierte Oberfläche weniger schnell aufgelöst wird als die unbehandelte glasige. Durch das unter der dünner werdenden Cristobalitschicht einsetzende Blasenwachstum abplatzende Cristobalitteilchen gelangen dabei in die Siliziumschmelze und können zu Versetzungen im Silizium-Einkristall führen. Aus diesem Grund ist das bekannte Verfahren bisher für die Herstellung von großen Quarzglastiegeln - die zur Aufnahme eines großen Schmelzvolumens vorgesehen sind und daher bestimmungsgemäß langen Prozesszeiten und damit starkem Blasenwachstum standhalten müssen - nicht geeignet.

Darüber hinaus kann beim Transport oder Handling des Quarzglastiegels Kristallisationspromotor abgerieben werden.

In der US 5,389,582 A ist ein Verfahren zur Herstellung eines Quarzglastiegels mittels Schlickergießen beschrieben, wobei ein mit einem Kristallisationspromotor versehener Quarzglasrohstoff eingesetzt und in die Tiegelwandung eingebracht wird. Die als Kristallisationspromotoren genannten Substanzen bilden beim Schlickergießen stabile Oxide, insbesondere Aluminiumoxide

Aus der gemäß Art. 54 (3) in Verbindung mit Art. 158 (1) und (2) zum Stand der Technik gehörenden WO 02 16677 A, und aus der EP 0 911 429 A1 sind Verfahren zur Herstellung eines Quarzglastiegels zum Einsatz in einem Siliciumkristall-Ziehprozess nach dem Czochralski-Verfahren Verfahren bekannt, bei denen ein Kristallisationspromotor in eine Zwischenschicht eingebracht wird, die sich zwischen dem Tiegelbasiskörper und der Innenschicht befindet. Während des bestimmungsgemäßen Einsatzes des Quarzglastiegels kommt aus ausgehend von dieser Zwischenschicht zu einer in Richtung auf die Innenoberfläche des Tiegels fortschreitenden Kristallisation. In der EP 0 911 429 A1 werden als Kristallisationspromotoren die Elemente der Gruppen 2a, 3a oder 3b des Periodensystems genannt.

Diese Verfahren haben den Nachteil, dass es zum Abplatzen von Teilen der Cristobalitschicht kommen kann. Dies ist insbesondere bei großvolumigen Quarzglastiegeln der Fall, die wegen ihrer großen Füllmenge langen Prozesszeiten standhalten müssen.Der Erfindung liegt die Aufgabe zugrunde, ein kostengünstiges Verfahren zur Herstellung von Quarzglastiegeln mit reproduzierbaren Eigenschaften für lange Standzeiten anzugeben.Diese Aufgabe wird ausgehend von dem eingangs genannten Verfahren erfindungsgemäß dadurch gelöst, dass in die Innenschicht der Kristallisationspromotor und eine während des Ziehprozesses mit gasfömigem Sauerstoff unter Bildung eines aufoxidierten Feststoffes reagierende reduzierend wirkende Substanz eingebracht werden.

Das erfindungsgemäße Verfahren weist gegenüber dem eingangs beschriebenen, bekannten Verfahren die folgenden wesentlichen Unterscheidungsmerkmale auf:

Erstens wird der Kristallisationspromotor in die Innenschicht eingebracht. Der Kristallisationspromotor ist somit in der Innenschicht enthalten und wirkt derart, dass er beim Aufheizen des Quarzglastiegels - etwa beim bestimmungsgemäßen Einsatz - zur Cristobalitbildung führt. Damit einhergehend kommt es zu der bekannten Wirkung der Cristobalitschicht, nämlich zu einer Verfestigung der Innenwandung und damit zu einer Erhöhung der thermischen Stabilität und der chemischen Beständigkeit des Tiegels. Eine unbeabsichtigte Veränderung der Konzentration - etwa durch Abrieb bei Transport oder Handling des Quarzglastiegels - ist ausgeschlossen.

Darüber hinaus erlaubt es das erfindungsgemäße Verfahren, eine vorgegebene Dicke der kristallisierten Innenschicht durch die entsprechende Verteilung und Konzentration des Kristallisationspromotors in der Innenschicht definiert einzustellen. Insbesondere wird auf einfache Art und Weise eine stärkere und stabilere kristallisierte Schicht als bei dem bekannten Verfahren erhalten. Schichtdicken von mehreren Millimetern sind erreichbar. Diese halten einem Blasenwachstum länger stand.

2. Zweitens wird in die Innenschicht eine reduzierend wirkende Substanz eingebracht. Die Substanz entfaltet mindestens während des Einbringens in die Innenschicht eine reduzierende Wirkung, die aber auch während des bestimmungsgemäßen Einsatzes des Quarzglastiegels noch fortbestehen oder wieder einsetzen kann. Dies führt zu einem überraschenden Effekt hinsichtlich der Standzeiten des Quarzglastiegels, was im Folgenden näher erläutert wird:

Es hat sich nämlich gezeigt, dass während des eingangs erwähnten allmählichen Ablösens der kristallisierten Innenschicht das Blasenwachstum in der Tiegelwandung grundlegende Bedeutung für die Haltbarkeit der kristallisierten Oberfläche hat. In der opaken Tiegelwandung ist eine Vielzahl von Blasen enthalten, in denen auch Gase eingeschlossen sein können. Infolge der hohen Temperatur beim Einsatz des Tiegels und insbesondere bei langen Prozesszeiten kommt es zu einem Wachsen gashaltiger Blasen, was durch die geringe Viskosität des Quarzglases bei diesen Temperaturen erleichtert wird. Wenn eine wachsende Blase eine dünne Cristobalitschicht berührt, führt das zu mechanischen Spannungen und zu lokalen Abplatzungen der Cristobalitschicht, und zwar umso eher, je dünner die Cristobalitschicht ist. Unter der Annahme, dass das Blasenwachstum maßgeblich durch sich bildenden Sauerstoff beeinflusst ist, könnte die dabei ablaufende chemische Reaktion anhand folgender Gesamtreaktionsgleichung beschrieben werden:

(1) 4 SiO₂₍ₛ₎ + C₍ₛ₎ + 2 N_{2(g)} → Si₃N₄₍ₛ₎ + SiC₍ₛ₎ + 4 O_{2(g)} s=solid (fest), g=gasförmig

Danach bilden sich unter Mitwirkung von Luftstickstoff und Kohlenstoff, der in kleinen Mengen in den Ausgangssubstanzen enthalten ist oder der während des Herstellungsprozesse in die Tiegelwandung eingetragen werden kann, aus jedem Mol Stickstoff das doppelte Volumen an Sauerstoff.

Ist jedoch eine reduzierend wirkende Substanz in der Innenschicht vorhanden, reagiert diese - mindestens während des Einbringens in die Innenschicht, vorzugsweise aber während des Ziehprozesses auch noch oder wieder - mit Sauerstoff bzw. dem eingebrachten Stickstoff unter Bildung eines aufoxidierten Feststoffes. Der Feststoff trägt zum Gesamt-Gasvolumen nicht bei. Diese "Getterwirkung" der reduzierend wirkenden Substanz vermindert somit die durch überschüssigen oder während des Ziehprozesses entstehenden Sauerstoff verursachte Blasenbildung.

Je stärker die reduzierende Wirkung der reduzierend wirkenden Substanz ist, umso besser wird ein Blasenwachstum verhindert. Ein etwaig vorhandener Sauerstoffunterschuss in der Quarzglasstruktur entfaltet diese Wirkung nicht. Erfindungsgemäß wird die reduzierend wirkende Substanz mindestens bei der Herstellung der Innenschicht erzeugt, so dass sie im Bereich der Innenwandung des Tiegels die beschriebene blasenmindernde Getterwirkung entfaltet. Gerade dort erweist sie sich als wesentlich, weil damit auch das durch Blasenwachstum hervorgerufene Abplatzen von Cristobalit vermieden und somit die Standzeit des Quarzglastiegels verlängert wird.

Das erfindungsgemäße Verfahren ermöglicht somit einerseits eine definierte und reproduzierbare Cristobalitbildung im Bereich der Innenwandung des Quarzglastiegels, und andererseits gewährleistet das Verfahren, dass diese Cristobalitschicht während des bestimmungsgemäßen Einsatzes des Quarzglastiegels möglichst unbeschädigt erhalten bleibt. Der mittels des erfindungsgemäßen Verfahrens hergestellte Quarzglastiegel hält daher langen Prozesszeiten stand. Erstmals wird der Einsatz großer Quarzglastiegel - die während ihres Einsatzes besonders langen Prozesszeiten standhalten müssen - mit kristallisierter Innenschicht ermöglicht, wobei das erfindungsgemäße Verfahren ein zusätzliches Aufbringen von Kristallisationspromotoren auf der Innenschicht des Quarzglastiegels nicht ausschließt.

Es wird eine Variante des erfindungsgemäßen Verfahrens bevorzugt, bei welcher mindestens ein Teil des Kristallisationspromotors gleichzeitig zur Bildung der reduzierend wirkenden Substanz in die Innenschicht eingebracht wird. Hierbei erfüllt der Kristallisationspromotor beide oben genannten Funktionen, indem er zum einen die Cristobalitbildung im Bereich der Innenwandung beim Wiederaufheizen des Quarzglastiegels fördert und gleichzeitig zur Bildung der reduzierend wirkenden Substanz beiträgt, die durch ihre "Getterwirkung" das Blasenwachstum mindert, und so einen festen Halt der Cristobalitschicht und damit eine lange Standzeit des Quarzglastiegels gewährleistet. Dabei wirkt entweder ein und dieselbe chemische Substanz als Element oder in einer chemischen Verbindung gleichzeitig kristallisationsfördernd und blasenreduzierend - also gleichzeitig als Kristallisationspromotor und als reduzierend wirkende Substanz. Oder es handelt sich dabei um eine chemische Verbindung, von der ein Teil eine Wirkung als Kristallisationspromotor und ein anderer Teil eine Wirkung als reduzierend wirkende Substanz im Sinn dieser Erfindung entfaltet.

Vorzugsweise werden durch Oxidation der reduzierend wirkenden Substanz solche Sauerstoff- oder Stickstoffverbindungen gebildet, die bis zu einer Temperatur von mindestens 1450°C als Feststoff vorliegen. Als reduzierend wirkende Substanzen kommen in erster Linie Metalle oder metallische Verbindungen in Frage, aber auch solche chemischen Verbindungen, die in einer geringeren als ihrer höchsten Oxidationsstufe in die Innenschicht eingebracht werden können. Wesentlich ist, dass die durch Aufoxidation der reduzierend wirkenden Substanz entstehenden chemischen Verbindungen als Feststoff anfallen und somit zum Gasvolumen innerhalb der Innenschicht und damit zur Blasenbildung nicht beitragen.

Es hat sich als besonders günstig erwiesen, die reduzierende Wirkung der Substanz dadurch einzustellen, dass reduzierende Bedingungen beim Herstellen der Innenschicht eingestellt werden. Dabei wird eine Ausgangssubstanz während der Herstellung der Innenschicht zu der reduzierend wirkenden Substanz reduziert. Das Redoxpotenzial der Ausgangssubstanz unterscheidet sich dabei von dem Redoxpotenzial von Silizium (IV), so dass eine Reduzierung der Ausgangssubstanz möglich ist, ohne dass SiO₂ in merkbarem Umfang reduziert wird.

Reduzierende Bedingungen beim Herstellen der Innenschicht lassen sich besonders einfach durch eine reduzierend wirkende Atmosphäre einstellen. Dadurch ist es möglich, die reduzierend wirkende Substanz aus einer Ausgangssubstanz (chemische Verbindung) zu bilden, die in einer hohen oder sogar in ihrer höchsten Oxidationsstufe vorliegt, unter der Voraussetzung, dass diese Ausgangssubstanz infolge der reduzierend wirkenden Atmosphäre reduziert wird. Dies ist vor allem bei chemischen Verbindungen der Fall, die leicht ihre Oxidationsstufe wechseln und durch CO reduzierbar sind, wie im Folgenden näher begründet wird.

Im Hinblick auf die Einstellung einer reduzierend wirkenden Atmosphäre hat es sich bewährt, die Innenschicht durch Lichtbogenschmelzen unter Einsatz mindestens einer Graphitelektrode herzustellen. Beim Lichtbogenschmelzen wird eine SiO₂₋haltige Körnung in einen Lichtbogen eingebracht und unter der Wirkung der vom Lichtbogen erzeugten Gasströmung gegen die Innenwandung des Tiegelbasiskörpers geschleudert und dort aufgeschmolzen. Im Bereich der Graphitelektrode oder der Graphitelektroden herrschen Temperaturen von einigen 1000°C, so dass der Graphit mit Sauerstoff reagiert, wobei sich aufgrund der hohen Temperatur vorwiegend reduzierend wirkendes Kohlenmonoxid bildet (Boudouard-Gleichgewicht). Aufgrund der CO-Bildung ergeben sich reduzierende Bedingungen bei der Herstellung der Innenschicht. Für die Bildung der reduzierend wirkenden Substanz in der Innenschicht sind daher sowohl Ausgangssubstanzen, die per se reduzierend wirken, als auch Ausgangssubstanzen, die unter den Bedingungen des Lichtbogenschmelzens reduziert werden, geeignet.

Unter Berücksichtigung dieser Randbedingung wird die reduzierend wirkende Substanz vorzugsweise aus einer Ausgangssubstanz gebildet, die eines oder mehrere der Elemente Titan, Wolfram, Molybdän, Silizium, Zirkonium oder eine Verbindung dieser Elemente enthält.Besonders bevorzugt wird die Innenschicht des Quarzglastiegels durch Lichtbogenschmelzen erzeugt indem in einen Lichtbogen eingebrachtes Einstreumaterial gegen die Innenwandung des Tiegelbasiskörpers geschleudert und dort aufgeschmolzen wird, wobei als Ausgangssubstanzen für die reduzierend wirkende Substanz Bariumtitanat (BaTiO₃) oder Bariumzirkonat (BaZrO₃) in einer Konzentration zwischen 0,003 mol-% bis 0,02 mol-% eingesetzt werden. Die Konzentrationsangabe bezieht sich auf die Konzentration im Einstreumaterial. Bariumtitanat bzw. Bariumzirkonat tragen als reduzierend wirkende Substanzen im Sinne der Erfindung nicht nur zu einer Blasenreduzierung bei, sondern wirken auch kristallisationsfördernd. Die Kristallisation wird durch den Barium-Anteil dieser Verbindungen gefördert, während sich die blasenreduzierende Wirkung durch den Bestandteil -TiO₃ bzw. -ZrO₃ im Zusammenspiel mit reduzierenden Bedingungen beim Herstellen der Innenschicht ergibt, indem diese Bestandteile zu Sub-Oxiden oder zu den Metallen reduziert werden. Dies gelingt, weil sich die Redoxpotenziale von Titan (IV) und Silizium (IV) stark voneinander unterscheiden, so dass Titan (IV) leichter zu reduzieren ist als Silizium (IV) und daher bei der Herstellung der Innenschicht von der Oxidationsstufe IV in signifikanten Mengen auf die Oxidationsstufe II oder III reduziert wird.

Außerdem zeichnen sich Barium und Titan sowie Zirkonium durch einen relativ kleinen Verteilungskoeffizienten in Silizium aus. Bei Konzentrationen unterhalb der genannten Untergrenze für den bevorzugten Konzentrationsbereich wird keine vollständige Kristallisation der Innenschicht erreicht. Dies gilt für den Fall einer Innenschicht aus sehr reinem, synthetischem SiO₂. Verunreinigungen im SiO₂ der Innenschicht fördern in der Regel die Cristobalitbildung, so dass bei verunreinigtem SiO₂ eine vollständige Kristallisation der Innenschicht auch bereits bei einem

BaTiO₃- oder BaZrO₃-Gehalt von weniger als 0,003 mol-% zu erwarten ist. Die angegebene Obergrenze des bevorzugten Konzentrationsbereichs ergibt sich aus dem Umstand, dass die Innenschicht während des Tiegeleinsatzes allmählich aufgelöst wird, so dass die darin enthaltenen Substanzen in die Metallschmelze gelangen und diese verunreinigen können. Besonders bevorzugt wird ein Konzentrationsbereich für Bariumtitanat bzw. Bariumzirkonat, der zwischen 0,005 mol-% bis 0,01 mol-% liegt.

Alternativ oder ergänzend dazu hat sich der Einsatz von Titansilizid und/oder Wolframsilizid in einer Konzentration zwischen 0,002 mol-% bis 0,5 mol-% als reduzierend wirkende Substanz als günstig erwiesen. Aufgrund des Siliziumanteils tragen Silizide weniger zur Verunreinigung einer Siliziumschmelze bei. Die angegebene Unter- bzw. die Obergrenze für den bevorzugten Konzentrationsbereich ergeben sich aus den oben für das Bariumtitanat erläuterten Erwägungen. Besonders bevorzugt wird ein Konzentrationsbereich für Titansilizid und/oder Wolframsilizid, der zwischen 0,004 mol-% bis 0,4 mol-% liegt.

Daneben erweisen sich Bariumsilizide insbesondere im Hinblick auf eine hohe kristallisationsfördernde Wirkung bei gleichzeitig möglichst geringer Verunreinigung der Siliziumschmelze als besonders geeignete reduzierend wirkende Substanz in der Innenschicht. Allerdings sind Bariumsilizide nicht stabil an feuchter Luft und erfordern daher einen Einsatz unter Schutzgasatmosphäre.

Insgesamt wird insbesondere für die nachfolgenden genannten Metalle eine Eignung als reduzierend wirkende Substanz und damit einhergehend eine blasenreduzierende Getterwirkung erwartet: W, Mo, Ba, Ti, Ga, Ge, In, Sn, TI, Pb, Zr, Si, Erdalkalimetalle, Seltenerdmetalle und Fe, ebenso wie für unter den Bedingungen des Kristallziehprozesses per se reduzierend wirkende chemische Verbindungen in Form von Hydriden, Nitriden, Siliziden. Auch chemische Verbindungen in Form von Oxiden, Carbonaten, Titanaten, Zirkonaten, Wolframaten, Molybdaten, Ferraten, Cobaltaten, Nickelaten, Vanadaten, Niobaten, Tantalaten und Chromaten sind unter der Voraussetzung reduzierender Bedingungen beim Herstellen der Innenschicht, - insbesondere einer reduzierenden Atmosphäre - als Ausgangssubstanzen für die Bildung einer reduzierend wirkenden Substanz im Sinne dieser Erfindung geeignet, wie oben erläutert wurde.

Von den genannten chemischen Verbindungen zeigen insbesondere die Kationen der Erdalkalimetalle und Oxide der Seltenerdmetalle sowie Ti, Al und Zr auch eine kristallisationsfördernde Wirkung in Quarzglas.

Es hat sich auch bewährt, reduzierend wirkende Substanzen in Form von Oxiden oder oxidische Verbindungen wie Ferraten, Wolframaten, Molybdaten, Nickelaten, Vanadaten, Niobaten, Tantalaten in nicht vollständig aufoxidierter Form einzusetzen.

Die reduzierend wirkende Substanz kann in fester, flüssiger oder gasförmiger Form in die Innenschicht eingebracht werden. Als besonders günstig hat es sich jedoch erwiesen, die Innenschicht mittels SiO₂-Körnung zu erzeugen, die die reduzierend wirkende Substanz oder einen Ausgangsstoff zur Bildung derselben in Form eines Dotierstoffs enthält. Dadurch wird eine besonders homogene und insbesondere eine definierte Verteilung der Substanz innerhalb der Innenschicht gewährleistet. Als Dotierstoff kann die reduzierend wirkende Substanz oder der Ausgangsstoff dafür in einer beliebigen Oxidationsstufe vorliegen, solange sichergestellt ist, dass beim Einbringen der Substanz in die Innenschicht eine reduzierende Wirkung erreicht wird.

Es hat sich auch bewährt, gleichzeitig mehrere reduzierend wirkende oder die Cristobalitbildung fördernde Substanzen mit unterschiedlicher chemischer Zusammensetzung in die Innenschicht einzubringen. Durch die freie Auswahl und Dosierung unterschiedlich wirkender Substanzen wird eine gleichzeitige Optimierung im Hinblick auf Getterwirkung und Cristobalitbildung vereinfacht.

Die reduzierend wirkende Substanz kann über die Tiegelwandung und insbesondere über die Dicke der Innenschicht gesehen, einen homogenen Konzentrationsverlauf aufweisen. Es hat sich aber auch als günstig erwiesen, in der Innenschicht einen Konzentrationsgradienten der reduzierend wirkenden Substanz einzustellen. Dabei zeigt die reduzierend wirkende Substanz über der Innenschicht einen Konzentrationsgradienten, mit einer vorzugsweise von Innen nach Außen ansteigenden Konzentration. Beim Ablösen von Cristobalit von der Innenschicht gelangt so möglichst wenig der reduzierend wirkenden Substanz in die Metallschmelze. Da beim Kristallziehprozess an der Innenwandung höhere Temperaturen als im Inneren der Tiegelwandung herrschen, genügt auch eine geringere Konzentration des Kristallisationspromotors (in Form der reduzierend wirkenden Substanz) für die Ausbildung einer dichten Cristobalitschicht. Andererseits entfaltet die reduzierend wirkende Substanz im Bereich der blasenhaltigen Außenschicht des Quarzglastiegels eine stärkere "Getterwirkung" aufgrund ihrer höheren Konzentration in diesem Bereich.

Vorzugsweise wird als Kristallisationspromotor Al₂O₃ in einer Konzentration zwischen 0,15 und 0,5 mol-%, bevorzugt zwischen 0,2 und 0,3 mol-%, eingesetzt. Die Konzentration an Al₂O₃ zur Einstellung einer vollständigen Kristallisation der Innenschicht ist überraschend hoch, was auf die geringe Kristallisationsneigung der Innenschicht aufgrund ihrer hohen Reinheit zurückzuführen ist.

In einer besonders bevorzugten Verfahrensvariante wird der Kristallisationspromotor nicht nur in die Innenschicht eingebracht, sondern außerdem in den Tiegelbasiskörper. Der Kristallisationspromotor ist dabei über die gesamte Wandstärke des Tiegelbasiskörpers verteilt, oder nur über einen Teil der Wandung. Der Tiegelbasiskörper besteht aus einem Bodenbereich und aus einer zylinderförmigen Seitenwandung. Der Kristallisationspromotor wird in den

Bodenbereich und/oder in mindestens einen Teil der Seitenwandung eingebracht. In den Tiegelbereichen, in denen Kristallisationspromotor enthalten ist, wird beim Einsatz des Quarzglastiegels eine Kristallisation hervorgerufen. Eine Kristallisation über den gesamten Tiegel wird erreicht, indem der Kristallisationspromotor im gesamten Tiegelbasiskörper in ausreichender Konzentration enthalten ist.

Hierbei ergibt sich eine weitere Verbesserung durch Reduzierung des Blasenwachstums, wenn die reduzierend wirkende Substanz ebenfalls in den Tiegelbasiskörper eingebracht wird. In dem Fall sind der Kristallisationspromotor und die reduzierend wirkende Substanz im Tiegelbasiskörper enthalten. Dies führt beim bestimmungsgemäßen Einsatz des Quarzglastiegels zu einer Kristallisation der betreffenden Tiegelbereiche unter Vermeidung oder Verminderung von Blasenbildung.

Nachfolgend wird die Erfindung anhand von Ausführungsbeispielen näher erläutert.

In einem ersten Verfahrensschritt wird ein Tiegelbasiskörper nach dem bekannten Verfahren hergestellt. Hierzu wird kristalline Körnung aus natürlichem Quarz mit einer Korngröße im Bereich von 90 µm bis 315 µm mittels Heißchlorierung gereinigt und in eine Metallform eingefüllt, die um ihre Längsachse rotiert. Unter der Wirkung der Zentrifugalkraft und Zuhilfenahme einer Schablone wird aus der Schüttung an der Innenwandung der Metallform eine rotationssymmetrische, gleichmäßig dicke Quarzkörnungs-Schicht geformt.

In einem zweiten Verfahrensschritt wird auf der Innenwandung der Quarzkörnungs-Schicht mittels des sogenannten "Lichtbogenschmelzens" eine transparente Innenschicht erzeugt. Hierzu wird unter anhaltender Rotation hochreine SiO₂₋Körnung in die Metallform eingestreut und mittels eines Lichtbogens, der von oben in die Metallform abgesenkt wird, erweicht, gegen die Innenwandung des Tiegelbasiskörpers geschleudert und darauf aufgeschmolzen. An der Innenwandung wird eine Maximaltemperatur von über 2100°C erreicht. Es bildet sich eine nach außen, in Richtung auf die Metallform, fortschreitende Schmelzfront, in deren Folge die Innenschicht zu einem transparentem Quarzglas erschmolzen und die Quarzkörnungs-Schicht zu dem Tiegelbasiskörper aus opakem Quarzglas gesintert wird. Das Erschmelzen wird beendet bevor die Schmelzfront die Metallform erreicht.

Der Lichtbogen wird unter Atmosphärenbedingungen (an Luft) durch drei Graphitelektroden gezündet. Durch Abbrand von Graphit bilden sich CO₂ und CO, wobei aufgrund der hohen Temperaturen von mehreren tausend Grad Celsius das Boudouard-Gleichgewicht deutlich zu Gunsten der CO-Bildung verschoben ist, so dass sich im Bereich des Lichtbogens eine reduzierende Atmosphäre einstellt.

Dabei werden in die Innenschicht eine reduzierend wirkende Substanz und ein Kristallisationspromotor im Sinne der vorliegenden Erfindung eingebracht. Die Herstellung der Innenschicht und das Einbringen des Kristallisationspromotors und der reduzierend wirkenden Substanz werden nachfolgend anhand von Ausführungsbeispielen näher erläutert:

### Beispiel 1:

SiO₂-Körnung wird mit 0,1 Gew.-% eines Fe₂O₃-Pulvers vermischt. Die Mischung wird in den opaken Tiegelbasiskörper eingestreut und dabei mittels des sogenannten "Einstreuverfahrens" unter Einsatz von Graphitelektroden, zwischen denen ein Lichtbogen erzeugt wird, erschmolzen und auf die Tiegel- Innenwandung unter Bildung einer transparenten Innenschicht geschleudert. Die Innenschicht erstreckt sich über den gesamten Tiegelbasiskörper und hat eine Dicke von 2 mm.

Die so erzeugte Innenschicht wurde anschließend einem sogenannten "Vacuum-Bake-Test" unterzogen, wobei die Druck- und Temperaturbedingungen beim Kristallziehprozess simuliert werden. Diese Probe wurde mit einer Vergleichsprobe, bei welcher die Innenschicht unter Einsatz eines Lichtbogens, aber ohne Zugabe eines Dotierstoffs erschmolzen wurde, verglichen. Im Vergleich zu dieser Probe wurde bei der Fe₂O₃-dotierten Innenschicht ein deutlich geringeres Blasenwachstum im Bereich der Innenschicht beobachtet, während die Oberfläche der Innenschicht Cristobalitbildung zeigte.

Ähnliche Versuche wurden mit den in Spalte 1 der Tabelle 1 genannten Substanzen durchgeführt. Die Konzentration dieser Substanzen in der Innenschicht war jeweils homogen verteilt und lag in der Regel bei 0,1 Mol-%. Sofern sich für die Einstellung der blasenreduzierenden Wirkung oder der kristallisationsfördernden Wirkung Konzentrationen in einem anderen Konzentrationsbereich als günstig erwiesen haben, wird dieser für die jeweilige Substanz in Tabelle 1 in Klammern angegeben.

**Tabelle 1**

| **"Ausgangssubstanzen zur Bildung reduzierender Substanzen und Kristallisationspromotoren"** | | |
|---|---|---|
| **Substanz / Verbindung** | **Wirkung** | |
| | **Blasenreduzierung** | **Cristobalitbildung** |
| W | Ja | Nein |
| Mo | Ja | Nein |
| WSi₂ | Ja (0,002 - 0,5 mol%) | Nein |
| TiSi₂ | Ja (0,002 - 0,5 mol%) | Nein |
| BaCO₃ | Gering (reduz. Atmosphäre) | Ja (0,003 - 0,02 mol%) |
| BaWO₄ | Mittel (reduz. Atmosphäre) | Ja (0,003 - 0,02 mol%) |
| BaZrO₃ | Mittel (reduz. Atmosphäre) | Ja (0,003 - 0,02 mol%) |
| BaTiO₃ | Stark | Ja (0,003 - 0,02 mol%) |
| Ti₂O₃ | Ja | Gering |
| TiO₂ | Ja (reduz. Atmosphäre) | |
| Al₂O₃ | Nein | Ja (0,15 bis 0,5 mol-%) |
| ZrO₂ | Kein Blasenwachstum feststellbar (reduz. Atmosphäre) | Ja |

Der Zusatz "reduz. Atmospähre" weist darauf hin, dass die betreffende Ausgangssubstanz ihre blasenreduzierende Wirkung unter der Voraussetzung reduzierender Bedingungen beim Herstellen der Innenschicht erhält.

Durch Zugabe von Al₂O₃wird lediglich eine Cristobalitbildung im Bereich der Innenschicht erzeugt, jedoch keine Verringerung des Blasenwachstums erreicht. Diese Substanz ist zur Durchführung des erfindungsgemäßen Verfahrens somit nur in Verbindung mit einer reduzierend wirkenden Substanz geeignet. Die Konzentration an Al₂O₃ zur Einstellung einer vollständigen Kristallisation ist überraschend hoch; der besonders bevorzugte Konzentrationsbereich liegt hier zwischen 0,2 und 0,3 mol-%. Dies wird auf die hohe Reinheit der eingesetzten SiO₂-Körnung zurückgeführt.

Die Metalle Wolfram und Molybdän und deren in der Tabelle 1 genannten metallischen Verbindungen (WSi₂) zeigen eine deutliche blasenreduzierende Wirkung, wogegen hier die kristallisationsfördernde Wirkung fehlt. Diese Substanzen sind zur Durchführung des erfindungsgemäßen Verfahrens somit nur in Verbindung mit einem geeigneten Kristallisationspromotor geeignet. Hinsichtlich Molybdän ist anzumerken, dass einige Oxidverbindungen dieses Metalls mit hoher Oxidationsstufe (insbesondere MoO₃) bei vergleichsweise niedrigen Temperaturen flüchtig sind und sich nachteilig auf die Blasenreduktion auswirken können. Unter reduzierende Bedingungen ist es aber einfach zu gewährleisten, dass metallisches Molybdän in die Innenschicht gelangt, bei dessen Oxidation solche Oxide oder Nitride entstehen, die bei der Temperatur der Siliziumschmelze fest sind.

Beim Einbringen von TiO₂ unter den reduzierenden Bedingungen des Lichtbogenschmelzens wurde eine blasenreduzierende Wirkung beobachtet, die auf die Bildung von Suboxiden des TiO₂ zurückzuführen ist. Außerdem zeigt sich eine geringfügige Cristobalitbildung, von der aber zu erwarten ist, dass sie durch höhere TiO₂-Dotierungen bei der Herstellung der Innenschicht verstärkt werden kann.

### Beispiel 2:

Zur Herstellung einer Innenschicht bei einem Quarzglastiegel wird SiO₂-Körnung mit 0,5 Gew.-% eines BaTiO₃-Pulvers vermischt und aus der Mischung - wie in Beispiel 1 anhand von SiO₂-Körnung beschrieben - mittels des sogenannten "Einstreuverfahrens" eine transparente Innenschicht unter Einsatz eines Lichtbogens erzeugt. Auch diese Innenschicht erstreckt sich über den gesamten Tiegelbasiskörper und hat eine Dicke von 3 mm.

Die Verbindung BaTiO₃ besteht aus einer die Kristallisation fördernden Komponente, nämlich dem Barium-Anteil, und einer Komponente mit blasenreduzierender Wirkung, nämlich dem Titanat-Anteil (TiO₃), wobei sich diese Wirkung erst beim Herstellen der Innenschicht durch das Einbringen in die Innenschicht unter reduzierenden Bedingungen ergibt. Durch den Lichtbogen wird der TiO₃-Anteil reduziert.

Die so erzeugte Innenschicht wurde einem Kristallisationstest unterzogen, wobei die Temperaturbedingungen der Aufschmelzphase zu Beginn der Kristallzucht simuliert werden. Dabei wurde eine sehr ausgeprägte Kristallisation der Innenschicht gefunden, die die Ermittlung der Wirkung auf das Blasenwachstum erschwerte. Soweit unter diesen Bedingungen messbar fand kein wesentliches Blasenwachstum statt. Die Konzentration an BaTiO₃ hat sich jedoch als unnötig hoch erwiesen.

### Beispiel 3:

Daher wurde in einem weiteren Versuch zur Herstellung einer Innenschicht bei einem Quarzglastiegel die eingesetzte SiO₂-Körnung lediglich mit 0,01 mol-% (etwa 0,05 Gew.-%) eines BaTiO₃-Pulvers vermischt und aus der Mischung - wie in Beispiel 2 anhand von SiO₂-Körnung beschrieben - mittels des sogenannten "Einstreuverfahrens" eine transparente Innenschicht unter Einsatz eines Lichtbogens erzeugt. Auch diese Innenschicht erstreckt sich über den gesamten Tiegelbasiskörper und hat eine Dicke von 3 mm.

Die so erzeugte Innenschicht wurde einem Kristallisationstest unterzogen. Dabei wurde eine nahezu vergleichbare Kristallisation der Innenschicht gefunden, die qualitativ als optimal eingestuft werden konnte.

### Beispiel 4:

Zur Herstellung einer Innenschicht bei einem Quarzglastiegel wird SiO₂-Körnung mit 0,005 mol-% eines BaWO₄-Pulvers vermischt und aus der Mischung - wie in Beispiel 1 anhand von SiO₂-Körnung beschrieben - mittels des sogenannten "Einstreuverfahrens" eine transparente Innenschicht unter Einsatz eines Lichtbogens erzeugt. Auch diese Innenschicht erstreckt sich über den gesamten Tiegelbasiskörper und hat eine Dicke von 3 mm.

Die Verbindung BaWO₄ besteht aus einer die Kristallisation fördernden Komponente, nämlich dem Barium-Anteil, und einer Komponente mit blasenreduzierender Wirkung, nämlich dem Wolframat-Anteil (WO₄), wobei sich diese Wirkung erst beim Herstellen der Innenschicht durch das Einbringen in die Innenschicht unter reduzierenden Bedingungen ergibt. Durch den Lichtbogen wird der WO₄-Anteil reduziert.

Die so erzeugte Innenschicht wurde einem Kristallisationstest unterzogen. Dabei wurde eine vergleichbare Kristallisation der Innenschicht wie in Beispiel 3 gefunden. Es ergab sich ein deutlich geringes Blasenwachstum als bei der Vergleichsprobe.

### Beispiel 5:

Zur Herstellung einer Innenschicht bei einem Quarzglastiegel wird SiO₂-Körnung mit 0,01 mol-% eines TiSi₂-Pulvers vermischt und aus der Mischung - wie in Beispiel 1 anhand von SiO₂-Körnung beschrieben - mittels des sogenannten "Einstreuverfahrens" eine transparente Innenschicht unter Einsatz eines Lichtbogens erzeugt. Auch diese Innenschicht erstreckt sich über den gesamten Tiegelbasiskörper und hat eine Dicke von 3 mm.

Die so erzeugte Innenschicht wurde einem "Vacuum- Bake-Test" unterzogen. Dabei wurde eine deutliche Verringerung des Blasenwachstums gefunden.

### Beispiel 6:

Es wird ein Tiegelbasiskörper nach dem eingangs beschriebenen Verfahren hergestellt. Kristalline Körnung aus natürlichem Quarz mit einer Korngröße im Bereich von 90 µm bis 315 µm wird mittels Heißchlorierung gereinigt und mit 0,01 mol-% (etwa 0,05 Gew.-%) BaTiO₃-Körnung mit einem ähnlichen Korngrößenspektrum vermischt. Die Mischung wird in eine Metallform eingefüllt, die um ihre Längsachse rotiert. Unter der Wirkung der Zentrifugalkraft und Zuhilfenahme einer Schablone wird aus der Schüttung an der Innenwandung der Metallform eine rotationssymmetrische, gleichmäßig dicke und homogen mit BaTiO₃ dotierte Quarzkörnungs-Schicht erzeugt. Auf der Innenwandung der Quarzkörnungs-Schicht wird anschließend durch "Lichtbogenschmelzen" eine transparente Innenschicht gemäß Beispiel 3. erzeugt. Die reduzierend wirkende Atmosphäre (CO-Bildung) bewirkt eine Reduzierung des Titanats zu Suboxiden von TiO₃, und zwar sowohl in der Innenschicht als auch in der Quarzkörnungs-Schicht. Der Bereich der Quarzkörnungs-Schicht bildet im Quarzglastiegel den "Tiegelbasiskörper".

Auf diese Weise wird ein Quarzglastiegel erhalten, dessen gesamte Wandung (Tiegelbasiskörper und Innenschicht) beim bestimmungsgemäßen Einsatz unter verminderter Blasenbildung kristallisiert.

## Patentansprüche

1. Verfahren zur Herstellung eines Quarzglastiegels zum Einsatz in einem Siliciumkristall-Ziehprozess nach dem Czochralski-Verfahren, in dem auf einem Tiegelbasiskörper aus Quarzglas mindestens teilweise eine Innenschicht aus SiO₂ unter Einsatz eines Lichtbogenschmeizverfahrens aufgeschmolzen wird, die beim bestimmungsgemäßen Einsatz des Quarzglastiegels mit einer Metallschmelze in Kontakt ist, und in welcher dabei unter Einsatz eines Kristallisationspromotors eine Cristobalitbildung herbeigeführt wird, **dadurch gekennzeichnet, dass** in die Innenschicht der Kristallisationspromotor und eine während des Ziehprozesses mit gasfömigem Sauerstoff unter Bildung eines aufoxidierten Feststoffes reagierende reduzierend wirkende Substanz eingebracht werden.

2. Verfahren nach Anspruch 1, **dadurch gekennzeichnet, dass** mindestens ein Teil des Kristallisationspromotors gleichzeitig zur Bildung der reduzierend wirkenden Substanz in die Innenschicht eingebracht wird.

3. Verfahren nach Anspruch 1 oder 2, **dadurch gekennzeichnet, dass** durch Oxidation der reduzierend wirkenden Substanz solche Sauerstoff- oder Stickstoffverbindungen gebildet werden, die bis zu einer Temperatur von mindestens 1450 °C als Feststoff vorliegen.

4. Verfahren nach einem der vorhergehenden Ansprüche, **dadurch gekennzeichnet, dass** die reduzierende Wirkung der Substanz durch reduzierende Bedingungen beim Herstellen der Innenschicht eingestellt wird.

5. Verfahren nach Anspruch 4, **dadurch gekennzeichnet, dass** die Innenschicht durch Lichtbogenschmelzen unter Einsatz mindestens einer Graphitelektrode hergestellt wird.

6. Verfahren nach einem der vorhergehenden Ansprüche, **dadurch gekennzeichnet, dass** die reduzierend wirkende Substanz aus einer Ausgangssubstanz gebildet wird, die eines oder mehrere der Elemente Titan, Wolfram, Molybdän, Silizium, Zirkonium oder eine Verbindung dieser Elemente - bevorzugt eine Erdalkalimetallverbindung dieser Elemente - enthält.

7. Verfahren nach Anspruch 6, **dadurch gekennzeichnet, dass** die Innenschicht des Quarzglastiegels durch Lichtbogenschmelzen erzeugt wird, indem in einen Lichtbogen eingebrachtes Einstreumaterial gegen die Innenwandung des Tiegelbasiskörpers geschleudert und dort aufgeschmolzen wird, und dass als Ausgangssubstanz für die reduzierend wirkende Substanz Bariumtitanat oder Bariumzirkonat in einer Konzentration zwischen 0,003 mol-% bis 0,02 mol-% im Einstreumaterial eingesetzt wird.

8. Verfahren nach Anspruch 7, **dadurch gekennzeichnet, dass** Bariumtitanat oder Bariumzirkonat in einer Konzentration zwischen 0,005 mol-% bis 0,01 mol-% eingesetzt wird.

9. Verfahren nach Anspruch 6, **dadurch gekennzeichnet, dass** als reduzierend wirkende Substanz Titansilizid und/oder Wolframsilizid in einer Konzentration zwischen 0,002 mol-% bis 0,5 mol-% eingesetzt wird.

10. Verfahren nach Anspruch 9, **dadurch gekennzeichnet, dass** Titansilizid oder Wolframsilizid in einer Konzentration zwischen 0,004 mol-% bis 0,4 mol-% eingesetzt werden.

11. Verfahren nach Anspruch 1, **dadurch gekennzeichnet, dass** als reduzierend wirkende Substanzen Oxide oder oxidische Verbindungen, insbesondere Ferrate, Wolframate, Molybdate, Nickelate, Vanadate, Niobate, Tantalate in nicht vollständig aufoxidierter Form eingesetzt werden.

12. Verfahren nach einem der vorhergehenden Verfahrensansprüche, **dadurch gekennzeichnet, dass** die Innenschicht mittels SiO₂-Körnung erzeugt wird, die die reduzierend wirkende Substanz oder einen Einsatzstoff zur Bildung der reduzierend wirkenden Substanz in Form eines Dotierstoffs enthält.

13. Verfahren nach einem der vorhergehenden Ansprüche, **dadurch gekennzeichnet, dass** gleichzeitig mehrere reduzierend wirkende Substanzen mit unterschiedlicher chemischer Zusarrimensetzung in die Innenschicht eingebracht werden.

14. Verfahren nach einem der vorhergehenden Ansprüche, **dadurch gekennzeichnet, dass** in der Innenschicht ein Konzentrationsgradient der reduzierend wirkenden Substanz eingestellt wird.

15. Verfahren nach einem der vorhergehenden Ansprüche, **dadurch gekennzeichnet, dass** als Kristallisationspromotor Al₂O₃ in einer Konzentration zwischen 0,15 und 0,5 mol-%, vorzugsweise zwischen 0,2 und 0,3 mol-% eingesetzt wird.

16. Verfahren nach einem der vorhergehenden Ansprüche, **dadurch gekennzeichnet, dass** der Kristallisationspromotor auch in den Tiegelbasiskörper eingebracht wird.

17. Verfahren nach Anspruch 16, **dadurch gekennzeichnet, dass** die reduzierend wirkende Substanz auch in den Tiegelbasiskörper eingebracht wird.

## Claims

1. A method of producing a quartz glass crucible, wherein a silicon crystal pulling process according to the Czochralski method is carried out, wherein an inner layer of SiO₂ is molten at least in part on a crucible base body of quartz glass using an arc melting method, which is in contact with a metal melt during the intended use of the quartz glass crucible, and in which the formation of cristobalite is induced using a crystallization promoter, **characterized in that** the crystallization promoter and a reducing substance reacting during the pulling process with gaseous oxygen under formation of an oxidized solid are introduced into the inner layer.

2. The method according to claim 1, **characterized in that** at least part of said crystallization promoter is introduced into said inner layer for forming said reducing substance at the same time.

3. The method according to claim 1 or 2, **characterized in that** those oxygen or nitrogen compounds that are present as solids up to a temperature of at least 1450°C are formed by oxidation of said reducing substance.

4. The method according to any one of the preceding claims, **characterized in that** the reducing action of said substance is adjusted by reducing conditions during preparation of said inner layer.

5. The method according to claim 4, **characterized in that** said inner layer is produced by arc melting using at least one graphite electrode.

6. The method according to any one of the preceding claims, **characterized in that** said reducing substance is formed from an initial substance which contains one or more of the elements titanium, tungsten, molybdenum, silicon, zirconium or a compound of said elements, preferably an alkaline-earth metal compound of said elements.

7. The method according to claim 6, **characterized in that** the inner layer of the quartz glass crucible is produced using an arc melting method, whereby spreading material is introduced into an arc and thrown against the inner wall of the crucible base body and is molten there, and that barium titanate or barium zirconate is used in a concentration between 0.003 mol % and 0.02 mol % in the spreading material as the initial substance for the reducing substance.

8. The method according to claim 7, **characterized in that** barium titanate or barium zirconate is used in a concentration between 0.005 mol % and 0.01 mol %.

9. The method according to claim 6, **characterized in that** titanium silicide and/or tungsten silicide is used in a concentration between 0.002 mol % and 0.5 mol % as the reducing substance.

10. The method according to claim 9, **characterized in that** titanium silicide or tungsten silicide is used in a concentration between 0.004 mol % and 0.4 mol %.

11. The method according to claim 1, **characterized in that** oxides or oxidic compounds, particularly ferrates, tungstates, molybdates, nickelates, vanadates, niobates, tantalates, in an incompletely oxidized form are used as reducing substances.

12. The method according to any one of the preceding claims of the method, **characterized in that** said inner layer is produced by means of SiO₂ grains which contain said reducing substance or a feed material for forming said reducing substance in the form of a dopant.

13. The method according to any one of the preceding claims, **characterized in that** a plurality of reducing substances of a different chemical composition are introduced into said inner layer at the same time.

14. The method according to any one of the preceding claims, **characterized in that** a concentration gradient of said reducing substance is set in said inner layer.

15. The method according to any one of the preceding claims, **characterized in that** Al₂O₃ is used in a concentration between 0.15 and 0.5 mol %, preferably between 0.2 and 0.3 mol %, as said crystallization promoter.

16. The method according to any one of the preceding claims, **characterized in that** the crystallization promoter is also introduced into the crucible base body.

17. The method according to claim 16, **characterized in that** the reducing substance is also introduced into the crucible base body.

## Revendications

1. Procédé pour la fabrication d'un creuset en verre de quartz pour l'emploi dans un processus d'étirage de cristal de silicium selon le procédé Czochralski dans lequel au moins partiellement une couche interne de SiO₂ est fondue sur un corps de base de creuset en verre de quartz en utilisant un procédé de fusion à l'arc, couche interne qui est en contact avec une fusion de métal pour un emploi conforme à la destination du creuset de verre de quartz, et couche dans laquelle il est provoqué une formation de cristobalite en utilisant un promoteur de cristallisation, **caractérisé en ce que** dans la couche interne, le promoteur de cristallisation et une substance agissant de manière réductrice pendant le processus de tirage avec de l'oxygène gazeux en formant une substance solide oxydée sont introduites.

2. Procédé selon la revendication 1, **caractérisé en ce qu'**au moins une partie du promoteur de cristallisation est introduite dans la couche interne simultanément pour la formation de la substance réductrice.

3. Procédé selon la revendication 1 ou 2, **caractérisé en ce que** par oxydation de la substance réductrice, il se forme des composés d'oxygène ou d'azote qui sont sous forme solide jusqu'à une température d'au moins 1450°C.

4. Procédé selon l'une des revendications précédentes, **caractérisé en ce que** l'effet réducteur de la substance est réglé par des conditions réductrices lors de la fabrication de la couche interne.

5. Procédé selon la revendication 4, **caractérisé en ce que** la couche interne est fabriquée par fusions d'arc en employant au moins une électrode graphite.

6. Procédé selon l'une des revendications précédentes, **caractérisé en ce que** la substance réductrice est composée d'une substance initiale qui contient un ou plusieurs des éléments tels que le titane, le tungstène, le molybdène, le silicium, le zirconium ou un composé de ces éléments - de préférence un composé de métaux alcalinoterreux de ces éléments.

7. Procédé selon la revendication 6, **caractérisé en ce que** la couche interne du creuset en verre de quartz est générée par fusion à l'arc dans le fait que le matériau pulvérisé introduit dans un arc électrique est propulsé contre la paroi interne du corps de base de creuset et y est fondu et **en ce qu'**en tant que substance initiale pour la substance réductrice, il est utilisé du titanate de baryum ou du zirconate de baryum en une concentration comprise entre 0,003 % molaire et 0,02 % molaire dans le matériau pulvérisé.

8. Procédé selon la revendication 7, **caractérisé en ce que** le titanate de baryum ou le zirconate de baryum est utilisé dans une concentration comprise entre 0,005 % molaire et 0,01 % molaire.

9. Procédé selon la revendication 6, **caractérisé en ce qu'**en tant que substance réductrice, il est utilisé du siliciure de titane et/ou du siliciure de tungstène dans une concentration entre 0,002 % molaire et 0,5 % molaire.

10. Procédé selon la revendication 9, **caractérisé en ce que** le siliciure de titane ou le siliciure de tungstène est utilisé dans une concentration comprise entre 0,004 % molaire et 0,4 % molaire.

11. Procédé selon la revendication 1, **caractérisé en ce qu'**il est utilisé en tant que substance réductrice, des oxydes ou composés oxydiques en particulier des ferrates, des tungstates de sodium, des molybdates, des nickelates, des vanadates, des niobates, des tantalates sous forme non complètement oxydée.

12. Procédé selon l'une des revendications précédentes, **caractérisé en ce que** la couche interne est générée au moyen du granulé SiO₂ qui comprend la substance réductrice ou une substance active pour la formation de la substance réductrice sous forme d'une substance de dopage.

13. Procédé selon l'une des revendications précédentes, **caractérisé en ce qu'**en même temps plusieurs substances réductrices de différentes compositions chimiques différentes sont insérées dans la couche interne.

14. Procédé selon l'une des revendications précédentes, **caractérisé en ce que** dans la couche interne, il est établi un gradient de concentration de la substance réductrice.

15. Procédé selon l'une des revendications précédentes, **caractérisé en ce qu'**en tant que promoteur de cristallisation il est utilisé de l'Al₂O₃ dans une concentration comprise entre 0,15 et 0,5 % molaire, de préférence entre 0,2 et 0,3 % molaire.

16. Procédé selon l'une des revendications précédentes, **caractérisé en ce que** le promoteur de cristallisation est également incorporé dans le corps de base de creuset.

17. Procédé selon la revendication 16, **caractérisé en ce que** la substance réductrice est également incorporée dans le corps de base de creuset.
